# EUROPEAN PATENT APPLICATION

(11) **EP 3 800 421 A1**
(43) Date of publication of application: **07.04.2021**
(21) Application number: 20209427.2
(22) Date of filing: 03.12.2014
(51) Int. Cl.: F28D 11/06, F28C 3/08, H01L 23/427, H01L 23/433, F28D 20/02

(54) **COMBINED ENERGY DISSIPATION APPARATUS**

(62) Divisional of application: 14907286.0
(71) Applicant: Intelligent Platforms, LLC., Charlottesville, VA 22911 (US)
(72) Inventor: Lueckenbach, William Henry, Hampstead, NC 28443 (US)
(74) Representative: Petraz, Gilberto Luigi

(57) **Abstract**

An apparatus and corresponding approaches for a combined energy dissipation include an energy dissipater forming a hollow chamber therein containing a partial pressure working fluid and a first adjustable thermal connector configured to be placed in an opening of the energy dissipater between an energy generating component to transfer energy there between. The first adjustable thermal connector includes a heat spreader at least partially disposed within the opening of the dissipater, an elastic member operably coupled to the energy dissipater, a flexible membrane coupled to the energy dissipater and the heat spreader, and a phase change material configured to at least partially fill an area defined by the opening, heat spreader, elastic member, and flexible membrane. Upon changing the phase change material to a first material phase, the elastic member applies a biasing force to the energy generating component to align the heat spreader with the energy generating component.

## Description

### Background of the Invention

### Field of the Invention

The subject matter disclosed herein generally relates to a combined energy dissipation apparatus.

### Brief Description of the Related Art

Electronic devices often produce heat during operation that needs to be dissipated from the device to ensure proper working conditions. To assist in dissipating the heat from the electronic device, energy dissipating devices such as heat sinks and/or other passive or active dissipation devices may be employed. In order to transfer heat from the electronic device, the dissipating device must be in thermal communication with the energy generating device.

A common arrangement for electronic devices is any number of electronic components coupled to a printed circuit board (PCB). During the assembly of these devices, non-planarity and height mismatches between the PCB and the energy dissipating device may occur, as each component on the PCB may be a particular distance from the energy dissipating device. Because these electronic devices may have varying dimensions, varying tolerances, or distances from the energy dissipating device, may occur.

When a single energy dissipating device serves multiple electronic components, the thermal connections oftentimes must accommodate these different tolerances. These tolerances are often filled with a thermal connector such as a heat spreader and/or thermal interface material. These thermal connectors may have low thermal conductivities, thus limiting the efficiency of heat dissipation.

In some approaches, the use of flexible energy dissipating components are provided as independent components that are inserted between the energy generating component and the energy dissipating component. This manufacturing process oftentimes requires a blind installation or fixture to assemble the energy dissipating components to the PCB, and may result in misalignment, which in turn may result in reduced energy dissipating efficiencies.

The above-mentioned problems have resulted in some user dissatisfaction with previous approaches.

### Brief Description of the Invention

The approaches described herein provide approaches that allow for the dissipation of energy and heat in electrical systems. By using the approaches described herein, portions of a thermal connector may be provided on a surface of the energy dissipating device. In some approaches, these thermal connectors include adjustable portions which may adjust to form thermal connections between energy generating devices. By incorporating any number of thermal connectors, varying tolerances may be accounted for, and thus thermal efficiency may be increased.

Furthermore, in some forms, the thermal connectors may be additively manufactured onto a surface of the energy dissipation device. By incorporating additive manufacturing into the systems, the precise location of the thermal connectors may be provided on the energy dissipating device to properly form a thermal
connection between the energy generating and dissipating devices.

In many of these embodiments, a combined energy dissipation apparatus includes an energy dissipater and a first adjustable thermal connector. The energy dissipater forms a hollow chamber therein and includes a working fluid, for example a partial pressure working fluid and is configured to passively dissipate thermal energy towards an edge of the energy dissipater. The first adjustable thermal connector is configured to be placed in an opening of the energy dissipater and be operably coupled thereto such that it is between an energy generating component and the energy dissipater to transfer energy from the energy generating component to the energy dissipater. This first adjustable thermal connector may include a heat spreader configured to be partially disposed within the opening of the energy dissipater, an elastic member configured to be operably coupled to the energy dissipater and to apply a biasing force to the heat spreader, a flexible membrane coupled to the energy dissipater and to the heat spreader and being configured to seal off the opening of the energy dissipater, and a phase change material configured to at least partially fill an area defined by the opening, the heat spreader, the elastic member, and the flexible membrane. The phase change material is configured to change from a first material phase to a second material phase.

Upon changing the phase change material to the first material phase, the elastic member applies the biasing force to the energy generating component to align the heat spreader with the energy generating component such that the heat spreader is in thermal contact with and is approximately coplanar to the energy generating component. Thus, the first adjustable thermal connector may adjustably form a thermal path between the energy generating device and the energy dissipater. In some examples, changing the phase material to the second material phase forms the solid thermal communication path from the energy generating component to the energy dissipater.

In some examples, the first adjustable thermal insert is directly coupled to the surface of the energy dissipater. Further, the elastic member may be additively manufactured directly onto the surface of the energy dissipater. Further still, in some examples, the heat spreader is additively manufactured onto a surface of one of the elastic member and the energy dissipater.

In further approaches, the first material phase is a generally liquefied phase. In these approaches, the second material phase is a generally solid phase. In some approaches, the apparatus may include any number of combined energy dissipation apparatuses which are configured to thermally couple to any number of energy generating components.

In other examples, the combined energy dissipation apparatus may include a second adjustable thermal connector. The second adjustable thermal connector may be configured to an opposing side of the energy dissipater to thermally couple to at least one energy generating component positioned on the opposing side of the energy dissipater. Accordingly, the combined energy dissipation apparatus may remove heat from energy generating components disposed on both sides of the energy dissipater.

In yet other examples, the combined energy dissipation apparatus may include a heat frame having an open portion for disposing the energy dissipater therein. The heat frame may be configured to couple to an external chassis to remove thermal energy.

### Brief Description of the Drawings

For a more complete understanding of the disclosure, reference should be made to the following detailed description and accompanying drawings wherein:
FIG. 1 comprises a perspective view of a combined energy dissipation apparatus according to various embodiments of the present invention;
FIG. 2 comprises an elevation view of the combined energy dissipation apparatus of FIG. 1 in a first configuration according to various embodiments of the present invention;
FIG. 3 comprises an elevation view of the combined energy dissipation apparatus of FIGS. 1-2 in a second configuration according to various embodiments of the present invention; and
FIG 4 comprises an operational flow chart illustrating a method, that is not part of the present invention, for providing a combined energy dissipation apparatus in accordance with various embodiments of the present invention.

Skilled artisans will appreciate that elements in the figures are illustrated for simplicity and clarity. It will further be appreciated that certain actions and/or steps may be described or depicted in a particular order of occurrence while those skilled in the art will understand that such specificity with respect to sequence is not actually required. It will al so be understood that the terms and expressions used herein have the ordinary meaning as is accorded to such terms and expressions with respect to their corresponding respective areas of inquiry and study except where specific meanings have otherwise been set forth herein.

### Detailed Description of the Invention

Approaches are provided that overcome the difficulty in removing heat from an energy generating device to an energy dissipating device. In one aspect, the systems are provided by inverting the energy dissipater and placing the adjustable thermal connector in the energy dissipater recess and placing the heat spreader thereon. The assembly is heated above the melting point of the phase change material, causing the phase change material to change phase so the assembly may be compressed and cooled in a disengaged state. After the phase change material has solidified, the flexible membrane is applied, thus covering the gap between the surface of the energy dissipater and the bottom of the adjustable thermal connector.

The energy dissipater and adjustable thermal connector are placed on top of an energy generating device while the adjustable thermal connector is in the compressed, disengaged state. The assembly is then heated above the melting point of the phase change material, thus causing the spring to move the heat spreader towards the energy generating component. This movement will accommodate any gap or tolerance and coplanarity variations between the energy dissipater and energy generating components. The assembly is then cooled, thus solidifying the phase change material to make a solid thermal connection between the energy dissipater, the adjustable thermal connector, and the energy generating device.

By additively manufacturing components of the thermal connector to be operably coupled to the energy dissipater, any number of thermal connectors may be correctly placed to form a strong thermal connection between the energy generating component and the energy dissipater. Further, the additive manufacturing process may allow for the manufacturing of intricate geometries of both the energy dissipater and the thermal connector to be incorporated into one device.

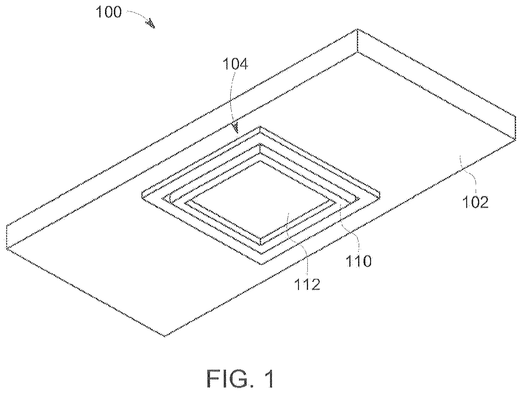

Referring now to FIGS. 1-3, one example of an apparatus 100 for combining energy dissipation is described. The apparatus 100 includes an energy dissipater 102, a first adjustable thermal connector 104 which includes an elastic member 106, a heat spreader 108, a phase change material110, and a flexible membrane 112, a circuit board 120, and an energy generating component or device 122.

The energy dissipater 102 may be any type of device configured to passively dissipate heat. In some forms, the energy dissipater 102 may be a vapor chamber or heat pipe forming a hollow chamber therein which contains a working fluid. In some forms, this working fluid is a partial pressure working fluid which requires a vacuum to be drawn in the hollow chamber prior to filling the hollow chamber with the working fluid. The hollow chamber is then sealed to create the partial pressure. It is understood that other types of working fluids, such as those that are not at a partial pressure, may be used. The energy dissipater 102 may be constructed of a metal, for example, an aluminum alloy. As such, the energy dissipater 102 may also include wicking structures to assist in transporting the condensed working fluid back to the warmer areas of the energy dissipater. The working fluid will then acquire the latent heat of vaporization, thus turning the working fluid into a vapor. The vapor then travels to the cooler, lower temperature areas of the energy dissipater and transmits the latent heat of vaporization which causes the working fluid to condense, which in turn allows the cycle to be completed again. In other forms, the energy dissipater 102 may be a generally solid heat sink used in conventional applications. It is understood that energy dissipaters and/or other passive dissipating devices are generally known by those having skill in the art, and thus further detail into their operation will not be provided. In yet other forms, the energy dissipater 102 may be configured to actively dissipate thermal energy.

The first adjustable thermal connector 104 is configured to be placed in an opening of the energy dissipater 102 and in close proximity to the energy generating component 122. The elastic member 106 may include a body portion and legs extending therefrom. In some forms, the legs may contact and extend from the energy dissipater 102, and in other forms, the body portion may contact the energy dissipater 102. In some examples, the elastic member 106 is a spring-type member.

The heat spreader 108 may be any commonly used device such as a copper plate that is configured to assist in heat dissipation. Other materials may be used, for example aluminum nitride plates. The heat spreader 108 may have any number of configurations and/or dimensions commonly used by those skilled in the relevant art. The heat spreader 108 is at least partially disposed within the opening of the energy dissipater 102. The elastic member 106 is configured to apply a biasing force to the heat spreader 108.

The flexible membrane 112 is coupled to the energy dissipater 102 and the heat spreader 108 and is configured to seal off the opening of the energy dissipater 102. The phase change material 110 is configured to at least partially fill an area defined by the opening, the heat spreader 108, the elastic member 106, and the flexible membrane 112. In other words, the flexible membrane 112 retains the phase change material 110 within this area when it is in the second material phase.

The flexible membrane 112 may be a plastic film or other polymer that is capable of withstanding the highest temperatures obtained by the energy generating device 122. The flexible membrane 112 may be constructed of polymers, silicon, urethane, rubbers, and/or metal foil, to name a few. Other examples are also envisioned. In some forms, the flexible membrane 112 is stable up to at least between 150 to 200 degrees Celsius. Other ranges are possible.

The phase change material 110 is configured to change from a first material phase to a second material phase. In some forms, the phase change material 110 is configured to be a generally solid material near room temperatures and a generally liquefied material at a higher temperature. As one example, the phase change material 112 may have a melting point generally between 40 to 250 degrees Celsius. In some forms, the phase change material 110 is a solder, or low-melting alloy such as In, InBi, variations of InSn, BiSn, PbSn, SnAg, InPbAg, InAg, InSnBi, InGa, SnBiZn, SnInAg, SnAgCu, SnAgBi, and/or InPb. Other examples of known materials, such as a paraffin wax, are envisioned.

The energy generating device 122 is any electronic device capable of connecting to any known circuit board 120. As these devices are commonly known by those skilled in the art, they will not be discussed in further detail.

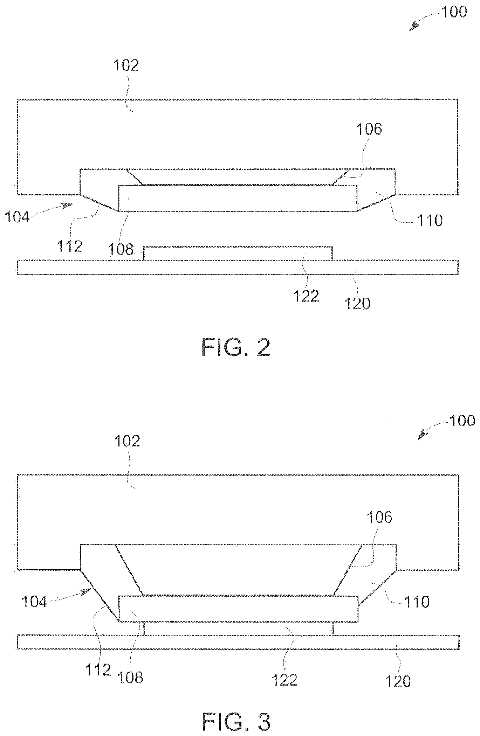

In operation, to assemble the apparatus 100, components of the first adjustable thermal insert 104 are additively manufactured to a surface of the energy dissipater 102. Such technologies include 3D printing, direct write, stereolithography, rapid prototyping, or any other process in which successive layers of a material are applied to a surface. In some forms, the elastic member 106 may be additively manufactured directly to a surface of the energy dissipater 102, which al so may undergo additive manufacturing processes to create any number of surfaces or components thereof. For example, the internal wicking structures of the energy dissipater 102 may be additively manufactured to provide precise placement for optimum energy dissipation. In some forms, at least a portion of the heat spreader 108 is also additively manufactured to a surface of the elastic member 106. The opening formed by the energy dissipater 102 is then filled with the phase change material 110 in the second, generally solid phase then heated to transition the phase change material 110 to the first, generally liquefied phase, and the heat spreader 108 is pressed towards the energy dissipater 102 and spring 106. The phase change material is then allowed to cool and turn to a second generally solid phase, at which point the flexible membrane 112 is applied to cover the opening. Thus, in this configuration, the first adjustable thermal connector is in a disengaged position (as shown in FIG. 2) when placed over the energy generating device 122.

As illustrated in FIG. 3, heat is applied to the apparatus 100 when it is properly positioned over the energy generating device 122 such that the phase change material 110 changes to the first, generally liquefied phase. The elastic member 106 then applies the biasing force to the heat spreader 108 which in turn exerts a force on the energy generating component 122 upon coming in contact therewith. As such, the heat spreader 108 is aligned with the energy generating component 122 such that the heat spreader 108 is in contact with and is approximately coplanar to the energy generating component 122. In some forms, at this point, the phase change material 110 may be cooled such that it return to the second, generally solid phase, to maintain the thermal connection between the first adjustable thermal connector 104 and the energy generating device 122. It is understood that in some forms, an additional material such as thermal paste may be disposed between the heat spreader 108 and the energy generating device 122.

In some forms, a plurality of apparatuses 100 and/or thermal connectors 104 may be coupled to any number of energy dissipating devices 122. As such a single energy dissipater 102 may have openings to accept multiple adjustable thermal connectors 104 to be thermally coupled to multiple energy generating devices 122. As such, if these energy generating devices 122 have differing tolerances, the adjustable thermal connectors 104 will be displaced varying distances to form a thermal connection with the energy generating devices 122. In other forms, individual energy dissipaters 102 may be disposed adjacent one another to thermally couple to multiple energy generating devices 122. It is understood that any combination of energy dissipaters 102 and/or adjustable thermal connectors 104 may be incorporated.

In yet other forms, a second adjustable thermal connector (not shown) is provided that is configured to couple to an opposing side of the energy dissipater 102. This second adjustable thermal connector is configured to thermally couple to at least one energy generating component positioned on the opposing side of the energy dissipater. As such, the apparatus is configured to remove heat from energy generating components disposed on both sides of the energy dissipater.

In additional examples, the apparatus 100 may include a heat frame having an open portion for disposing the energy dissipater therein. This heat frame may be configured to couple to an external chassis to assist in the removal of thermal energy.

It is understood that in some forms, the energy generating component may reach a temperature which causes the phase change material 110 to return to the first, generally liquefied phase. In these forms, the phase change material 110 may be configured to store a portion of the energy generated by the energy generating device 122 using the latent heat of fusion. As such, a short-term increase of thermal energy may be appropriately controlled to reduce the possibility of the apparatus 100 being incapable of dissipating a short term increase in the generated energy.

In other examples, flexible membrane 112 may be removed. Upon removing the flexible membrane 112, the dissipation apparatus 100 may be oriented such that when the phase change material 110 is in the second material phase, the phase change material 110 is supported in the area defined by the opening, the heat spreader 108, and the elastic member 106 by gravitational forces. In this example, there is no "sealing" of this opening, thus the phase change material 110 may flow freely throughout the opening and the apparatus 100.

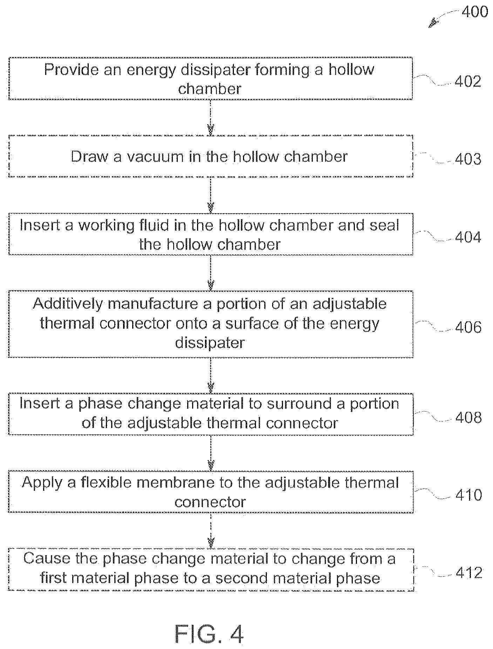

Referring now to FIG. 4, one example of a method 400 for providing a combined energy dissipation apparatus is described. First, at step 402, an energy dissipater is provided which forms a hollow chamber.

Next, at optional step 403, a vacuum may be drawn in the hollow chamber. At step 404, a working fluid is then inserted therein, and the hollow chamber is sealed. The optional step 403 serves to create a partial pressure working fluid if so desired. At step 406, the method 400 additively manufactures a portion of an adjustable thermal connector onto a surface of the energy dissipater. It is understood that the step 406 of additively manufacturing a portion of the adjustable thermal connector may occur before the steps 403,404 of drawing a vacuum and inserting the working fluid.

At step 408, a phase change material is inserted to surround a portion of the thermal connector. At step 410, a flexible membrane is applied to the adjustable thermal connector.

In some forms, the step 406 of additively manufacturing a portion of the adjustable thermal connector onto a surface of the energy dissipater may include additively manufacturing an elastic member configured to be operably coupled to the energy dissipater and to apply a force to a heat spreader. This additive manufacturing may occur directly on the surface of the energy dissipater. Further still, the step 404 of additively manufacturing a portion of the adjustable thermal connector onto a surface of the energy dissipater may include additively manufacturing a heat spreader to at least one of the elastic member and the energy dissipater.

In other examples, the method 400 includes the step 412 of causing the phase change material from a first material phase to a second material phase. Causing the phase change material to change from the first to the second material phase further causes the adjustable thermal insert to move from a first position to a second position in which a portion of the adjustable thermal insert is thermally coupled to an energy generating device. It will be understood that the steps of the method 400, including optional steps, may be performed in any desirable order.

It will be appreciated by those skilled in the art that modifications to the foregoing embodiments may be made in various aspects. Other variations clearly would also work, and are within the scope and spirit of the invention. The present invention is set forth with particularity in the appended claims. It is deemed that the spirit and scope of that invention encompasses such modifications and alterations to the embodiments herein as would be apparent to one of ordinary skill in the art and familiar with the teachings of the present application.

## Claims

1. A combined energy dissipation apparatus (100) comprising:
an energy dissipater (102) forming a hollow vapor chamber therein, the energy dissipater (102) containing a working fluid, the energy dissipater (102) being operative to passively dissipate thermal energy towards an edge thereof;
a first adjustable thermal connector (104) placed in an opening of the energy dissipater (102) between an energy generating component (122) and the energy dissipater (102) to transfer energy from the energy generating component (122) to the energy dissipater (102), the first adjustable thermal connector (104) comprising:
a heat spreader (108) at least partially disposed within the opening of the energy dissipater (102);
an elastic member (106) operably coupled to the energy dissipater (102), the elastic member (106) further applying a biasing force to the heat spreader (108);
a flexible membrane (112) coupled to the energy dissipater (102) and to the heat spreader (108), the flexible membrane (112) sealing off the opening of the energy dissipater (102);
a phase change material (110) at least partially filling an area defined by the opening, the heat spreader (108), the elastic member (106), and the flexible membrane (112), the phase change material (110)changing from a first material phase to a second material phase and storing a portion of the energy generated by the energy generating component (122) using latent heat of fusion;
wherein the first adjustable thermal connector (104) is operably coupled to a surface of the energy dissipater (102), and wherein upon changing the phase change material to the first material phase, the elastic member (106) of the first adjustable thermal connector (104) applies the biasing force to the energy generating component (122) to align the heat spreader (108) with the energy generating component (122) such that the heat spreader (108) is it in contact with and is approximately coplanar to the energy generating component (122).

2. The combined energy dissipation apparatus (100) of claim 1, wherein changing the phase change material to the second material phase forms a solid thermal communication path from the energy generating component (122) to the energy dissipater (102).

3. The combined energy dissipation apparatus (100) of claim 2, wherein the elastic member (106) of the first adjustable thermal connector (104) is coupled directly onto the surface of the energy dissipater (102).

4. The combined energy dissipation apparatus (100) of claim 3, wherein the heat spreader (108) is disposed onto a surface of one of the elastic member (106) and the surface of the energy dissipater (102).

5. The combined energy dissipation apparatus (100) of claim 1, wherein the first material phase is a liquefied phase and the second material phase is a solid phase.

6. The combined energy dissipation apparatus (100) of claim 5, wherein upon removing the flexible membrane (112), the dissipation apparatus (100) is oriented such that when the phase change material is in the first material phase, the phase change material is supported in the area defined by the opening, the heat spreader (108), and the elastic member (106) by gravitational forces.

7. The combined energy dissipation apparatus (100) of claim 1, further comprising a plurality of combined energy dissipation apparatuses (100) thermally coupled to a plurality of energy generating components (122).

8. The combined energy dissipation apparatus (100) of claim 1, further comprising a second adjustable thermal connector coupled to an opposing side of the energy dissipater (102), the second adjustable thermal connector being thermally coupled to at least one energy generating component (122) positioned on the opposing side of the energy dissipater (102) such that the combined energy dissipation apparatus (100) removes heat from energy generating components (122) disposed on both sides of the energy dissipater (102).

9. The combined energy dissipation apparatus (100) of claim 1, further comprising a heat frame having an open portion for disposing the energy dissipater (102) therein, wherein the heat frame is coupled to an external chassis to remove thermal energy.

10. The combined energy dissipation apparatus (100) of claim 1, wherein the working fluid comprises a partial pressure working fluid, wherein a vacuum is drawn in the hollow chamber prior to insertion of the partial pressure working fluid.
